Europäisches Patentamt

European Patent Office

Office européen des brevets

(19)

(11) EP 0 575 622 B1

(12)

# EUROPEAN PATENT SPECIFICATION

(45) Date of publication and mention
of the grant of the patent:
**07.04.1999   Bulletin 1999/14**

(21) Application number: 92924910.0

(22) Date of filing: 11.12.1992

(51) Int Cl.⁶: **G01M 17/00**, G01R 31/00,
H02J 1/14, F02D 41/08

(86) International application number:
PCT/JP92/01621

(87) International publication number:
**WO 93/12412 (24.06.1993 Gazette 1993/15)**

(54) **Electrical Load Level Detector and Method of and Apparatus employing the same**

Elektrischer Lastdetektor und Verfahren und Vorrichtung zu dessen Verwendung

Equipment déterminant l'intensité de charge électrique et méthode et appareil utilisant ledit équipement

(84) Designated Contracting States:
**DE FR GB IT**

(30) Priority: **13.12.1991   JP   351867/91**

(43) Date of publication of application:
**29.12.1993   Bulletin 1993/52**

(73) Proprietor: **THE FURUKAWA ELECTRIC CO., LTD.**
**Tokyo 100 (JP)**

(72) Inventors:
 • **KATO, Mitsunori The Furukawa Electric Co., Ltd.**
**Chiyoda-ku Tokyo 100 (JP)**
 • **ITABASHI, Shigeki**
**The Furukawa Electric Co., Ltd.**
**Chiyoda-ku Tokyo 100 (JP)**

(74) Representative: **Modiano, Guido, Dr.-Ing. et al**
**Modiano, Josif, Pisanty & Staub,**
**Baaderstrasse 3**
**80469 München (DE)**

(56) References cited:
**EP-A- 0 281 152          JP-A-63 009 870**
**JP-A-63 027 769          US-A- 4 463 341**

 • **GEC REVIEW, vol.2, no.1 pages 32 - 36 W.R.**
**BETTS 'Multiplexing for the automotive**
**industry'**
 • **Proceedings of the 24th Intersociety Energy**
**Conversion Engineering Conference, 6th-11th**
**August1989, Washington D.C., USA, Vol. 1,**
**pages 159-164, M. Bouzguenda et al.,**
 • **Book no. , 1973, 'GEBäUDE AUTOMATION;**
**STROMANWENDUNGEN,**
**ELEKTROINSTALLATION, AUTOMATION UND**
**INFORMATIK IM MODERNEN HOCHBAU',**
**MIERENDORFF, J. VDE-VERLAG GMBH,**
**BERLIN (DE)**

**Description**

Technical Field

The present invention relates to an electrical load level detector for detecting the load level of load devices in an electric system designed for multiplex transmission, e.g., load devices in an electric system of a motor vehicle, a method of and a device employing the electrical load level detector.

Background Art

In general, an electric system of a motor vehicle has a battery and a generator (driven by an engine) which are connected in parallel to load devices. In the power system for a vehicle, the power generating voltage of the generator is set at about 14V which is higher than 12V, the full-charge voltage of the battery, so that currents of a maximum of several tens of amperes can be supplied according to load level.

The output of the generator, however, fluctuates according to the operation state of load devices and the output of the engine which drives the generator changes accordingly. The fluctuations in the output of the generator present no particular problem as long as the motor vehicle is traveling smoothly, but if a high electrical load is applied during idling, then the fluctuations in the output cause a drop in the engine speed, occasionally stopping the engine.

To prevent such a problem, in an electric system in the field of engine revolution control, for example, there are conventional methods such as the so-called idling acceleration method wherein the operation states (ON/OFF states) of the switches of diverse load devices are detected, the detected states are compared with the switch operation states which are defined in advance, and a control signal is issued from an idling acceleration decision circuit if it is determined that the level of the applied electrical load has exceeded a specified value so that the idling acceleration actuator is controlled by the control signal to increase the idling number of revolutions, and in a method wherein the load currents supplied to load devices are directly detected by a current detector circuit, an idling acceleration decision circuit decides whether the idling should be accelerated according to the detected current level, and an idling acceleration control command is issued if it is decided to accelerate the idling, thus controlling the actuator by the control command to increase the idling number of revolutions.

In the former detection method of electrical load level, however, each load device needs to be provided with wiring for detecting its ON/OFF state. Hence, the wiring inevitably becomes complicated as the number of load devices used in the electric system increases. For this reason, the detection of the ON/OFF state is limited to large-current loads, presenting a problem of poor accuracy of current detection.

Also in the latter detection method of electrical load level, if the current detector circuit is designed so that a detecting resistor is connected in series with a battery, the load current is detected based on a potential difference across the resistor. Therefore, it is necessary to use a detecting resistor with low resistance to minimize a drop in the voltage supplied to load devices, thus presenting a problem of poor accuracy of current detection.

There is still another method wherein a current detector circuit employs a current detecting sensor having a magnetism-sensitive element incorporated in a magnetic core, to prevent a drop in the supply voltage. This method, however, presents a problem in that the magnetism-sensitive element varies significantly in sensitivity, requiring correction of such variations at the time of assembly and resulting in higher cost of components.

Further, the detection level is low in both the current detector circuit wherein the detecting resistor is connected in series with the battery and the current detector circuit using the magnetism-sensitive element incorporated in the magnetic core; therefore, a signal amplifier circuit is required. Also, both circuits handle the information on detected current in terms of analog values, requiring a analog/digital converter circuit or a comparator circuit such as a comparator for analog value comparison. Thus, they present a problem of more parts with resultant higher cost.

Mierendorff J. describes in *"Gebäudeautomation";* Stromanwendung, Elektroinstallation, Automation und Informatik im modernen Hochbau; VDE-Verlag GmbH, Berlin, 1973; pages 34-45, an energy management system for buildings which supervises the general building power consumption and controls the loads when the power consumption exceeds a defined level.

A strategy for managing loads on board a space station is taught by Bouzguenda, M. and Rahman, S. in *"A knowledge-based approach to optimize the supply and usage of electricity on board the space station",* Proceedings of the 24th Intersociety Energy Conversion Engineering Conference, 6th-11th August 1989, Washington D.C., U.S.A., Vol.1, pages 159-164. The known strategy includes controlling, scheduling and managing loads according to precalculated load data which is represented in form of tables.

EP-A-281 152 discloses a method for controlling the fuel supply to an engine (engine rotational speed) when an air conditioner switch is turned on.

Betts, W.R. describes in *"Multiplexing for the Automotive Industry",* GEC Review, Vol. 2, No. 1, pages 32-36, a load control system utilizing multiplex transmission.

Disclosure of the Invention

An object of the present invention is to provide an electrical load level detector, its usage and applied devices which feature simple wiring and a moderate price and which permit highly accurate detection of an electrical load level.

Another object of the present invention is to provide an electrical load level detector, its usage and applied devices which are capable of accurately detecting at an average level the magnitude of load devices, which operate intermittently, among the load devices in operation in an electric system, without increasing the signal quantity on a multiplex transmission line.

To fulfill the above-mentioned objects, an electrical load level detector in accordance with claim 1 is provided.

Further provided are methods of employing such load level detectors according to claims 6 and 7 and devices which employ such load level detectors according to claims 8 and 10. Further advantageous features are defined in the dependent claims.

Preferably, a numerical data table stores the average value data for continuous load devices, which operate continuously, separately from the average value data for intermittent load devices, which operate intermittently, and an arithmetic circuit calculates the electrical load level according to data concerning the control of the load devices taken in via the multiplex transmission line and the stored average value data.

Further preferably, the arithmetic circuit performs corrective calculation of the average value data for working intermittent load devices out of the average value data stored in the numerical data table according to the data on the pause or operation time of the intermittent load devices.

As described above, according to the present invention, the numerical data table has the average value data of continuous load devices and the average value data of intermittent load devices. This makes it possible for the arithmetic circuit to calculate the magnitude of load devices by using the average value data for continuous loads and intermittent loads, respectively, which are currently in operation in the electric system, permitting further accurate determination of the magnitude by calculating the magnitude of an intermittent load device in operation at an average level which has been subjected to corrective calculation. Also in the case of motor speed control or the like based on the PWM (pulse width modulation) system wherein the actuation instruction signal based on turning ON of a switch is different from a load driving signal and the load driving signal is not sent to the multiplex transmission line, it is not necessary to send the load driving signal to the multiplex transmission line merely to detecting the level of a load device; therefore, there will be no increase in the quantity of signals on the transmission line.

Brief Description of the Drawings

The drawings illustrate an embodiment according to the present invention.

FIG. 1 is a principle drawing of a controller which uses the electrical load level detector according to the present invention;

FIG. 2 is a block diagram which shows the first embodiment of an engine speed controller which employs the electrical load level detector according to the present invention;

FIG. 3 is an explanatory drawing of a current $I_{INT}$ of a wiper in the engine speed controller shown in FIG. 2 when the wiper is in its intermittent operation;

FIG. 4 is a block diagram which shows the second embodiment of the engine speed controller employing the electrical load level detector according to the present invention;

FIG. 5 is an explanatory drawing of the current $I_{INT}$ of the wiper in the engine speed controller shown in FIG. 4 in its intermittent operation when the intermittent pause time is standard and the current $I_{INT}$ of the wiper when the intermittent pause time is not standard;

FIG. 6 is a block diagram showing an example of an electrical load controller which uses the electrical load level detector according to the present invention.

Best Mode for Carrying Out of the Invention

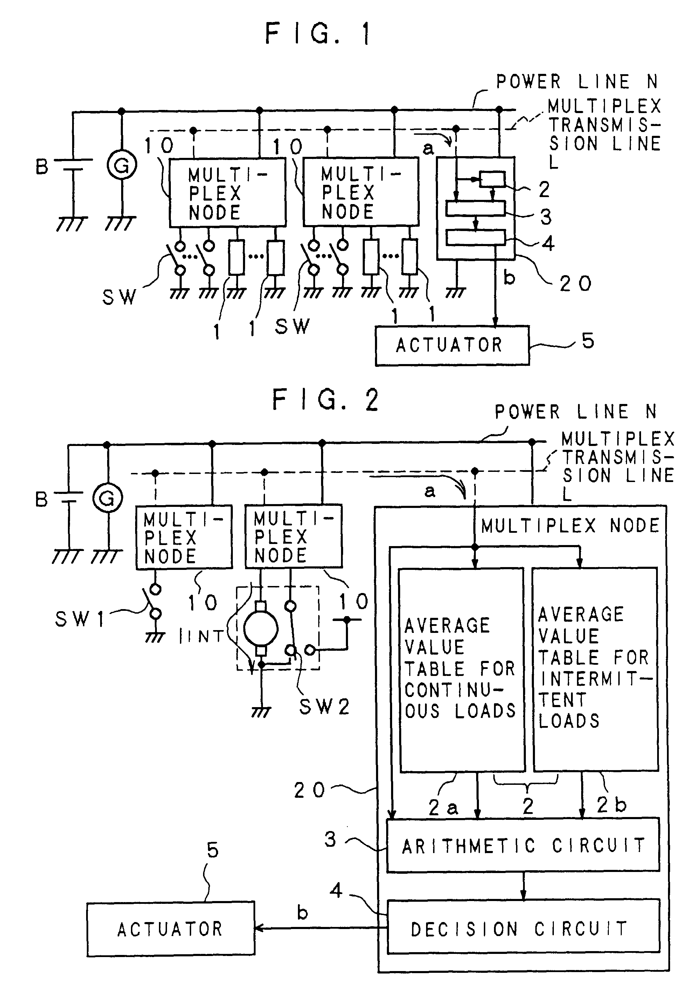

The following describes the embodiment of the present invention with reference to FIG. 1 through FIG. 6.

FIG. 1 shows the principle of the controller which employs the electrical load level detector according to the present invention.

Referring to FIG. 1, multiplex nodes 10 and 20 connected to a common multiplex transmission line L which is shown by a one-dot chain line configure a multiplex transmission system for an electric system in a motor vehicle, the multiplex transmission system making use of the data communication functions, not shown, of the nodes 10 and 20 for mutual data transmission. Further, the multiplex nodes 10 and 20 are connected to a power unit (e.g., a battery) B and an engine-driven generator G via a power line N shown by a solid line.

The power unit B and the generator G are connected in parallel to multiplex nodes 10 and 20 and they supply power to a power circuit for a control circuit, not shown, in the multiplex nodes 10 and 20 and to various load devices 1 connected to the multiplex nodes 10 and 20. The load devices 1 include various lamps, motors, air conditioner, heater, rear defogger, and communications equipment.

The multiplex nodes 10 transmit to the multiplex nodes 10 and 20 control-related information "a" such as the turning ON of a switch for executing operation instructions for the diverse load devices connected to the multiplex node 10 (the multiplex node of its own station and/or other station) via the multiplex transmission line L by using the communication function described above.

Referring to FIG. 2, the multiple node 20 has, in addition to the communication function described above, a numerical data table 2 in which the data of the diverse load devices 1 existing on the multiplex transmission system are stored, an arithmetic circuit 3 which calculates the load levels of the load devices 1, and a decision circuit 4 which decides whether to issue an operation instruction to an actuator 5 according to a calculation result given by the arithmetic circuit. The multiplex node 20 takes in the control-related information "a" from each multiplex node 10 via the communication function.

The average value data for the individual load devices are stored in the numerical data table 2. The average value data include rated load values and rated load capacities, for example.

The arithmetic circuit 3 integrates all the load capacities (e.g., rated load values) presently in operation in the system. In other words, when the multiplex node 20 takes in the control-related information "a" from both multiplex nodes 10, the arithmetic circuit 3 takes in the load capacity of each load device in operation in the system from the numerical data table 2 in response to the control-related information "a", integrates these electrical load levels to determine the total electrical load, and issues the calculation result to the decision circuit 4.

When the decision circuit 4 takes in the calculation result from the arithmetic circuit 3, the decision circuit decides whether it should issue an operation instruction "b" to the actuator 5 according to the calculation result. For example, when the controller controls the speed of the engine, the current supplied from the power unit B and the generator G to the engine varies with the changes in the output of the load currents supplied to the individual load devices. Hence, when the decision circuit 4 decides that the input electrical load value, which is the calculation result, has reached the specified value or more, the decision circuit issues the idling acceleration control command signal (operation command) "b" for the engine speed control to prevent the engine from stopping due to the output fluctuations which in turn lower the engine speed. It is also possible to provide the decision circuit 4 in a multiplex node 10 other than the multiplex node 20 and to control the engine speed by the data on the idling acceleration control command transmitted via the multiplex transmission line L from the multiplex node 20. In this case, shorter and simplified wiring can be achieved by providing the decision circuit in a multiplex node near the engine.

The actuator 5 consists of an idling acceleration actuator, for example, and its operation is controlled based on the idling acceleration control command signal to increase the idling number of revolutions of the engine. In some cases, the actuator 5 may be provided with a power generating voltage regulator circuit designed to regulate the excitation of the field winding of the generator G.

If the switch SW or the load devices 1 are installed near the multiplex node 20, it is alternatively possible to send the control-related information directly to the multiplex node 20, bypassing the multiplex transmission line L.

The information on the total electrical load calculated by the arithmetic circuit 3 is used for other purpose than just controlling the engine speed and power generating voltage. To be more specific, the information on the total electrical load can also be sent from the multiplex node 20 to other multiplex nodes 10 controlling the diverse load devices 1 via the multiplex transmission line L in order to actively reduce the total power consumption, considering the charge state of the battery or the power generating capacity of the generator as it will be discussed later. This makes it possible to change the control mode of the diverse load devices, thereby controlling the power consumption.

FIG. 2 is the block diagram showing the first embodiment of the engine speed controller which uses the electrical load level detector according to the present invention. One of the load devices is, for example, a wiper motor.

Referring to FIG. 2, the numerical data table 2 is provided with a numerical data table 2a which stores the average value data for the continuous loads, which operate continuously, among the load devices 1, and a numerical data table 2b which stores the average value data for the intermittent loads, which operate intermittently. The average value data of the numerical data table 2a for a continuous load is, for instance, the rated load value of a head lamp or the like which operates continuously. The average value data of the numerical data table 2b for an intermittent load is, for example, the average current value or the like of an intermittent wiper, turn signal, hazard signal or other PWM-controlled loads. The numerical data table 2a for the continuous loads and the numerical data table 2b for the intermittent loads may be combined into one table rather than two separate ones.

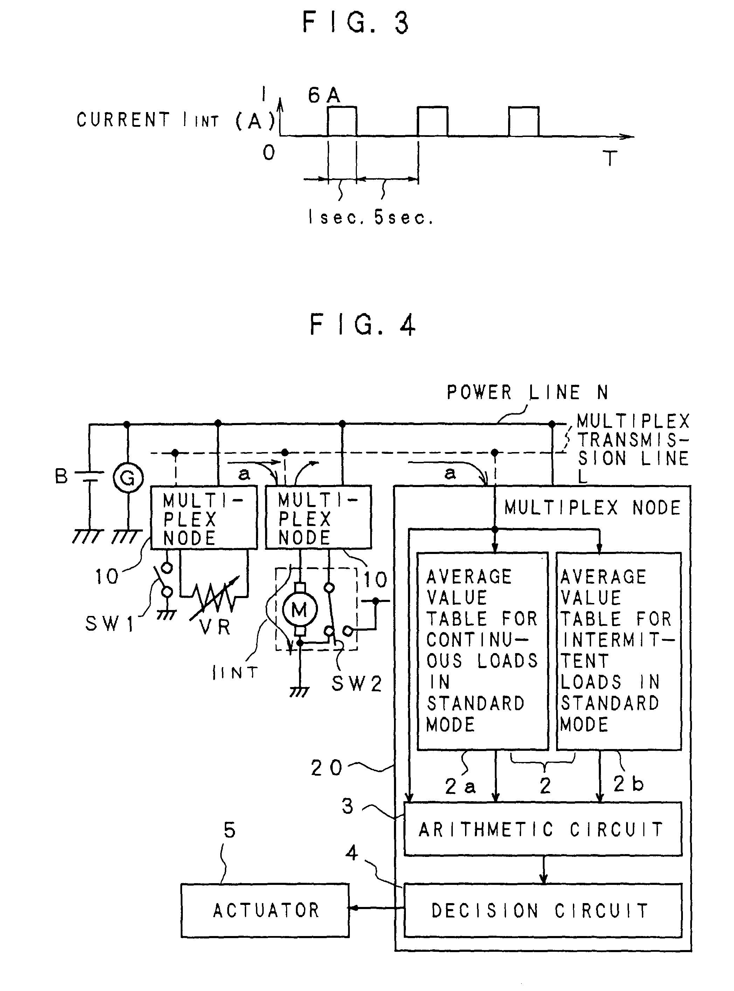

If the wiper, which is a load device 1, has the current $I_{INT}$ with a peak value of 6A, a supply time of 1 second, and a pause time of 5 seconds as shown in FIG. 3 when the wiper is in its intermittent operation, the average current value of the intermittent wiper is:

$$6 \, [A] \times \{1 \, / \, (1 + 5)\} = 1 \, [A]$$

The average current value, 1A, obtained during the intermittent operation of the wiper is saved in the numerical data table 2b for the intermittent load. Incidentally, in the past, the intermittent load was either ignored or a fixed peak value, 6A, was used; therefore, it was impossible to accurately determine the magnitude of the load devices in operation in the system at the average level. Further, according to the present invention, the average current value, 6A, which is obtained during the continuous operation of the wiper, can be saved as the average value in the standard mode in the numerical data table and the information on the turning ON of the wiper intermittent operation switch SW can be used as the corrective information, so that the average current of the intermittent wiper can be determined by the corrective calculation.

A wiper intermittent switch SW1 is connected to the first multiplex node 10 of the multiplex nodes 10. Connected to the second multiplex node 10 are a wiper motor M for intermittently driving a wiper (not shown) which functions as a load device, and a switch SW2 interlocked with the drive of the motor M.

When the intermittent switch SW1 is turned ON, the first multiplex node 10 transmits the control-related information "a", which is the turning ON information, to the second multiplex node 10 and the multiplex node 20. This causes the second multiplex node 10 to intermittently drive the wiper motor and the multiplex node 20 to read out the average value data from the numerical data table 2B for the intermittent loads which corresponds to that particular control-related information "a" and applies it to the arithmetic circuit 3.

In this case, the control-related information "a" includes the turning-ON information of the continuous loads which are connected to the multiplex nodes 10 and which continuously operate. The multiplex node 20 reads also the numerical data from the numerical data table 2a for the continuous load which corresponds to that particular control-related information "a" and sends it to the arithmetic circuit 3. The arithmetic circuit 3 calculates the magnitude (total load capacity) of the load devices including the intermittent wiper in operation in the system.

Hence, in this embodiment, the average value data for the continuous loads and intermittent loads in operation in the system are read from the numerical data table and the average value data are used to calculate the magnitude of the continuous loads and intermittent loads when they are in operation. This makes it possible to accurately determine the magnitude of the continuous loads and intermittent loads when they are in operation, thus permitting accurate control of the idling speed of the engine to be controlled.

Also in the case of this embodiment, the load capacity in the system is calculated based on the control-related information on the load devices gathered through the multiplex transmission line; therefore, the connection wiring can be simplified. In addition, when an intermittent load is turned ON, only the control-related information, by which it is determined whether an intermittent load has been turned ON, has to be transmitted. This eliminates the need of the transmission of the information of the ON and OFF signals of the intermittent load, thus controlling the increase of signals and preventing the increase of the delay of transmission.

Further, in this embodiment, the electrical load level can be handled in terms of digital numerical values; therefore, it is not necessary to provide the decision circuit or the like with an analog/digital converter circuit or a comparison circuit such as a comparator for comparing analog values, thus permitting reduction in the manufacturing cost.

Furthermore, in this embodiment, the average value data of the load devices in the standard mode which are stored in the numerical data table are subjected to corrective calculation based on the turning-ON information which is the corrective information. This enables still more accurate determination of the magnitude of the load devices in operation in the system.

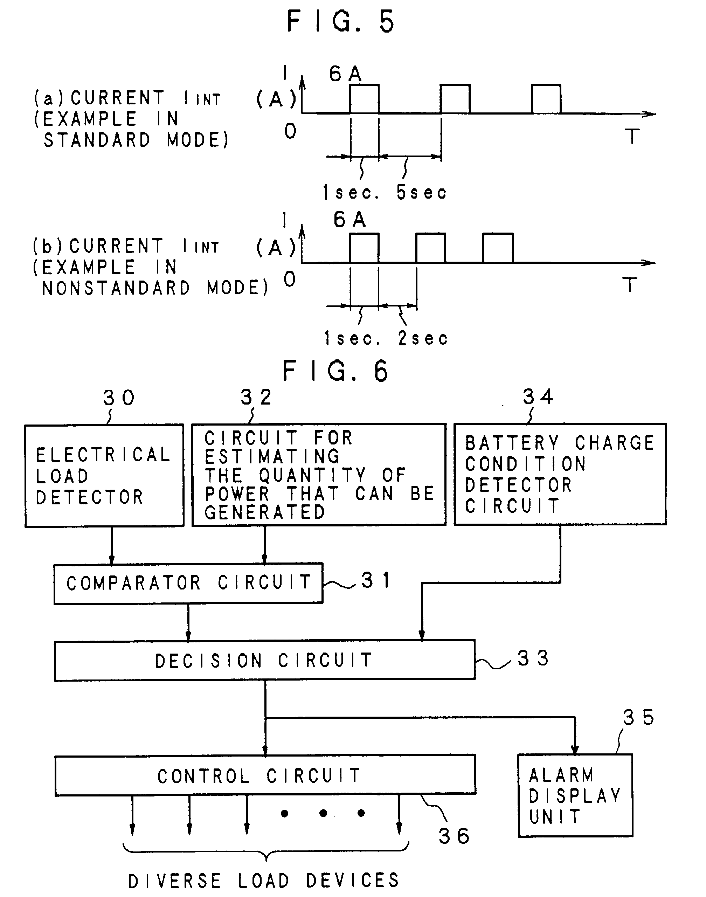

FIG. 4 is a block diagram which shows the second embodiment of the engine speed controller employing the electrical load level detector according to the present invention like in FIG. 2. One of the load devices is, for instance, a wiper and the numerical data table 2 is provided with the numerical data table 2a for continuous loads and the numerical data table 2b for intermittent loads. In this case also, as it is shown in FIG. 5(a), the current $I_{INT}$, which is obtained when the wiper is in its intermittent operation, has the same waveform as that shown in FIG. 3, and the average current value which is obtained when the intermittent wiper is in the standard mode is:

$$6 \, [A] \times \{1 \, / \, (1 + 5)\} = 1 \, [A]$$

The average data in this standard mode is saved in the numerical data table 2b for intermittent loads. The average value data for the continuous loads in the standard mode are stored in the numerical data table 2a for continuous loads.

Connected to the first multiplex node 10 of the multiplex nodes 10 are a wiper intermittent switch SW1 and a variable resistor VR used to set the intermittent pause time of the wiper for the desired value (e.g., a value within a range of 1sec. to 10sec.). Connected to the second multiplex node 10 is a wiper motor M which functions as a load device, the intermittent pause time thereof can be changed.

When the intermittent switch SW1 is turned ON, the first multiplex node 10 transmits the control-related information "a" including the turned-ON information, the information on the wiper intermittent pause time, and the information on the continuous loads to the second multiplex node 10 and the multiplex node 20. This causes the second multiplex node 10 to intermittently drive the wiper motor M according to the turned-ON information and the information on the wiper intermittent pause time and also to include the turned-ON information on the continuous loads of its own station in the control-related information "a".

The multiplex node 20 reads out the average value data in the standard mode for the continuous loads and intermittent loads which correspond to the control-related information "a" from the numerical data tables 2a and 2b and supplies it to the arithmetic circuit 3. The arithmetic circuit 3 calculates the magnitude (total load capacity) of the load devices in operation in the system according to the average value data from the numerical data tables 2a and 2b corresponding to the control-related information "a". Further, the arithmetic circuit 3 decides whether the pause time is standard according to the information on the wiper intermittent pause time received. If the arithmetic circuit 3 decides that the pause time is not standard, then it carries out the corrective calculation if the actual system has the pause time set for 2sec., for example, as shown in FIG. 5(b) while the standard current pause time is 5sec., for example, as shown in FIG. 5(a). The computation formula used in this case is shown below:

$$\text{Standard average current value } 1 \text{ [A] } \times \{(1 + 5) / (1 + 2)\} = 2 \text{ [A]}$$

Thus, in this embodiment, the current value of the average current (see FIG. 5 (b)) of the intermittent wiper in the case where the intermittent pause time thereof is not standard, can be calculated.

According to the present invention, it is also possible to perform corrective calculation by regarding the information on the car speed as the above-mentioned information on the pause time in the case of a system wherein the intermittent pause time changes with the car speed.

In the present invention, the information used as the corrective information is not limited to the information on the pause time mentioned in the embodiment; it may also be the information on operation time or duty ratio incorporating the former information, the information on temperature, the information on battery voltage, the information on the power generating voltage or the like, depending on, for example, the type of load and control method (e.g., in the case of PWM control).

Hence, in this embodiment, the average value data in the standard mode for the intermittent loads, which data permit changes of setting or flexible control stored in the numerical data table, are subjected to corrective calculation based on the information on the pause time or operation time which is the corrective information. This enables still more accurate determination of the magnitude of the load devices in operation in the system.

Furthermore, in this embodiment, it is not necessary to save the average value data for each pause time or operation time in the numerical data table, thus preventing the memory area of the numerical data table from expanding and also preventing the cost of the multiplex nodes to increase.

The following explains about an embodiment wherein the electrical load level detector according to the present invention is used in the load device controller of a motor vehicle.

Referring to FIG. 6, an electrical load level detector 30 is an electrical load level detector (specifically, the numerical data table 2 and the arithmetic circuit 3) in the multiplex node 20 shown in the embodiment of FIG. 2 or FIG. 4. The electrical load level detector 30 supplies the calculation result of the electrical load to a comparator circuit 31 which is a comparing means.

A generable-power quantity estimating circuit 32 calculates the quantity of power that can be generated by the generator according to the information on the characteristics of the maximum power generating current with respect to the number of revolutions of the generator and to the information on the number of revolutions of the generator which is driven by the engine. The circuit 32 supplies the estimated value to the comparator circuit 31. The generable-power quantity estimating circuit 32 is capable also of carrying out corrective computation of the quantity of power that can be generated according to the information on the temperature or the like of the generator. The output of the quantity of power that can be generated may alternatively be a current value or an electric energy value according to the calculation result of the electrical load.

The comparator circuit 31 compares the output received from the detector 30 with the output received from the estimating circuit 32 and supplies the magnitude relationship between the electrical load and the quantity of power that can be generated to a decision circuit 33. If the electrical load exceeds the quantity of power that can be generated, it is judged that the battery is supplying discharge current to the load device.

A charge condition detector circuit 34 detects whether the charge condition of the battery is good or not based on, for instance, the specific gravity of the electrolyte, then it supplies the detection result to the decision circuit 33 which is a deciding means. For determining whether the charge condition is good or bad, there is a method wherein a reference specific gravity value is preset, and if a detected specific gravity value is smaller than the preset value, then it is decided that the charge condition is bad while it is decided that the charge condition is good if a detected specific gravity value is larger than the preset value, the decision result being output. The condition of battery charge may be determined also by integrating the terminal voltages of the battery or the charge/discharge currents of the battery. In addition, as necessary, the detection accuracy can be improved by adding corrective processing to a detected specific gravity according to the temperature of the battery.

Based on the output received from the comparator circuit 31 and the output received from the detector circuit 34, the decision circuit 33 determines whether it is necessary to control the load device to reduce the electrical load. Table 1 below shows an example of the decision processing.

Table 1

|  | Condition of Battery Charge | |
| --- | --- | --- |
|  | Good | Bad |
| Electrical Load < Power which can be generated | No load device control to reduce electrical load | No load device control to reduce electrical load |
| Electrical Load > Power which can be generated | No load device control to reduce electrical load | Execute load device control to reduce electrical load |

According to Table 1 above, if, for example, the electrical load exceeds the quantity of power that can be generated and the battery is overloaded, developing a bad condition of battery charge, then the decision circuit 33 sends a control instruction for reducing the operation of a load device or stopping the load device to the control circuit 36 which is the controlling means and it also sends an execution instruction to an alarm display unit 35 which is an alarming means. These control instruction and execution instruction may also be transmitted to other associated multiplex nodes via the multiplex transmission line as necessary.

The control circuit 36 controls the load device to reduce the operation of the load device or stop the load device in response to the control instruction. The alarm display unit 35 informs the crew of the need to execute the control through the control circuit 36 in accordance with the execution instruction.

Accordingly, in this embodiment, the load devices are controlled by comparing and determining the electrical load detected by the electrical load detector according to the quantity of power that can be generated and the condition of battery charge. This enables stable control of load devices to prevent problems such as battery exhaustion even when an intermittent load is working. Where technical features mentioned in any claim are followed by reference signs, those reference signs have been included for the sole purpose of increasing the intelligibility of the claims and accordingly, such reference signs do not have any limiting effect on the scope of each element identified by way of example by such reference signs.

## Claims

1. An electrical load level detector for detecting the load level of operating electrical load devices (1) in a multiplex transmission system wherein a plurality of multiplex nodes (10, 20) having various electrical load devices (1) are interconnected via a common multiplex transmission line (L) to mutually transfer data,
characterized by arithmetic means (3) for calculating the load level of operating electrical load devices (1) according to data (a) related to the control of the individual load devices (1), received from the multiplex nodes (10, 20) via the multiplex transmission line (L) and to stored average value data associated with the individual load devices (1) connected to the multiplex nodes (10, 20), said stored average value data being stored in a numerical data table (2) of said electrical load level detector.

2. The electrical load level detector according to claim 1, characterized in that said arithmetic means (3) calculates the electrical load level of the operating electrical load devices (1) in accordance with the data (a) related to the control of the individual load devices (1) received via the multiplex transmission line (L) and stored average value data associated with continuous load devices which are continuously operated and/or stored average value data associated with intermittent load devices which are intermittently operated, among the various electrical load devices.

3. The electrical load level detector according to claim 1 or 2, characterized in that said arithmetic means (3) performs corrective calculation of stored average value data associated with intermittent load devices in operation, based on data representing the pause or operation time of the individual intermittent load devices.

4. The electrical load level detector according to claim 1, 2 or 3, characterized in that said arithmetic means (3) corrects an electrical load level calculated based on stored average value data associated with the load devices (1) in standard mode, in accordance with correction data received via the multiplex transmission line (L).

5. The electrical load level detector according to claim 4, characterized in that the correction data includes data related to the pause or operation time of individual intermittent loads in operation, and said arithmetic means (3) corrects the stored average value data associated with the intermittent loads in accordance with the data related to the pause or operation time of the individual intermittent loads.

6. A method of employing the electrical load level detector according to any one of claims 1 through 5 connected to a multiplex transmission system of an automotive electric system, characterized by

   determining whether a command (b) related to the speed control of an engine should be issued or not according to the load level calculated by the arithmetic means (3) based on the data (a) related to the control of the individual electrical load devices (1) and the stored average value data, and
   changing the idling speed of the engine in accordance with the issued command (b).

7. A method of employing the electrical load level detector according to any one of claims 1 through 5 connected to a multiplex transmission system of an automotive electric system, characterized by

   estimating the quantity of power that can be generated by a generator (G) driven by an engine,
   detecting the charge condition of a battery (B) connected in parallel with the generator (G),
   comparing the estimated quantity of power with the load level calculated by the arithmetic means (3),
   determining whether a command related to the control of the electrical load devices (1) should be issued or not according to the comparison result and the detected charge condition of the battery (B), and
   controlling the reduction in the operating level and the stoppage of the electrical load devices (1) and issuing an alarm in accordance with the issued command.

8. A device which employs the electrical load level detector according to any one of claims 1 through 5 connected to a multiplex transmission system of an automotive electric system, characterized by

   deciding means for determining whether a command (b) related to the speed control of an engine should be issued or not according to the load level calculated by the arithmetic means (3) based on the data (a) related to the control of the individual electrical load devices (1) and the stored average value data, and by
   changing means (5) for changing the idling speed of the engine in accordance with the issued command (b).

9. The device according to claim 8, characterized in that said changing means (5) comprises an actuator.

10. A device which employs the electrical load level detector according to any one of claims 1 through 5 connected to a multiplex transmission system of an automotive electric system, characterized by

   estimating means (32) for estimating the quantity of power that can be generated by a generator (G) driven by an engine,
   comparing means (31) for comparing the load level calculated by the arithmetic means (3) with the estimated quantity of power from said estimating means (32),
   detecting means (34) for detecting, in relation to the electrical load devices (1), the charge condition of a battery (B) connected in parallel with the generator (G),
   deciding means (33) for determining whether a command related to the control of the load devices should be issued or not according to the comparison result and the detected charge condition,
   controlling means (36) for controlling the reduction in the operating level or the stoppage of the load devices (1) in accordance with the issued command, and
   alarming means (35) for issuing an alarm in accordance with the issued command.

**Patentansprüche**

1. Ein elektrischer Lastdetektor zur Erfassung des Lastpegels von in einem Multiplex-Übertragungssystem in Betrieb befindlichen elektrischen Lastvorrichtungen (1), worin eine Mehrzahl der Multiplexknoten (10, 20), die über verschiedene elektrische Lastvorrichtungen (1) verfügen, über eine gemeinsame Multiplex-Übertragungsleitung (L) verbunden sind, um gegenseitig Daten zu übertragen,
gekennzeichnet durch ein Arithmetikmittel (3), um den Lastpegel der in Betrieb befindlichen elektrischen Lastvorrichtungen (1) gemäß von Daten (a) zu berechnen, die die Steuerung der einzelnen Lastvorrichtungen (1) betreffen, die über die Multiplex-Übertragungsleitung (L) von den Multiplexknoten (10, 20) empfangen werden, und gemäß von gespeicherten Durchschnittswertdaten zu berechnen, die mit den mit den Multiplexknoten (10, 20) verbundenen einzelnen Lastvorrichtungen (1) verknüpft sind, wobei die gespeicherten Durchschnittswertdaten in einer numerischen Datentabelle (2) des elektrischen Lastdetektors gespeichert werden.

2. Der elektrische Lastdetektor gemäß Anspruch 1, dadurch gekennzeichnet, daß das Arithmetikmittel (3) den elektrischen Lastpegel der im Betrieb befindlichen elektrischen Lastvorrichtungen (1) in Übereinstimmung mit den die Steuerung der einzelnen Lastvorrichtungen (1) betreffenden Daten (a) berechnet, die über die Multiplex-Übertragungsleitung (L) empfangen werden, und in Übereinstimmung mit den Durchschnittswertdaten berechnet, die mit den kontinuierlichen Lastvorrichtungen verknüpft sind, die kontinuierlich betrieben werden, und/oder in Übereinstimmung mit den gespeicherten Durchschnittswertdaten berechnet, die mit den diskontinuierlichen Lastvorrichtungen verknüpft sind, die unter den verschiedenen elektrischen Lastvorrichtungen diskontinuierlich betrieben werden.

3. Der elektrische Lastdetektor nach Anspruch 1 oder 2, dadurch gekennzeichnet, daß das Arithmetikmittel (3) auf der Grundlage der Daten, die die Pausen- oder Betriebszeit der einzelnen diskontinuierlichen Lastvorrichtungen darstellen, die korrigierende Berechnung der gespeicherten Durchschnittswertdaten durchführt, die mit den in Betrieb befindlichen diskontinuierlichen Lastvorrichtungen verknüpft sind.

4. Der elektrische Lastdetektor nach Anspruch 1, 2 oder 3, dadurch gekennzeichnet, daß das Arithmetikmittel (3) einen elektrischen Lastpegel, der auf der Grundlage der mit den Lastvorrichtungen (1) im Standardmodus verknüpften gespeicherten Durchschnittswertdaten berechnet wird, in Übereinstimmung mit den Korrekturdaten korrigiert, die über die Multiplex-Übertragungsleitung (L) empfangen werden.

5. Der elektrische Lastdetektor nach Anspruch 4, dadurch gekennzeichnet, daß die Korrekturdaten Daten einschließen, die die Pausen- oder Betriebszeit der einzelnen in Betrieb befindlichen diskontinuierlichen Lasten betreffen, und daß das Arithmetikmittel (3) die gespeicherten Durchschnittswertdaten, die mit den diskontinuierlichen Lasten verknüpft sind, in Übereinstimmung mit den Daten korrigiert, die die Pausen- oder Betriebszeit der einzelnen diskontinuierlichen Lasten betreffen.

6. Ein Verfahren zum Verwenden des elektrischen Lastdetektors nach irgendeinem der Ansprüche 1 bis 5, der mit einem Multiplex-Übertragungssystem eines elektrischen Kraft fahrzeugsystems verbunden ist, gekennzeichnet durch

   die Bestimmung, ob ein Befehl (b), der die Drehzahlsteuerung eines Motors betrifft, erzeugt werden sollte oder nicht, und zwar gemäß dem Lastpegel, der auf der Grundlage der Daten (a), die die Steuerung der einzelnen elektrischen Lastvorrichtungen (1) betreffen, und auf der Grundlage der gespeicherten Durchschnittswertdaten durch das Arithmetikmittel (3) berechnet wird, und
   die Änderung der Leerlaufdrehzahl des Motors in Übereinstimmung mit dem erzeugten Befehl (b).

7. Ein Verfahren zur Verwendung des elektrischen Lastdetektors nach irgendeinem der Ansprüche 1 bis 5, der mit einem Multiplex-Übertragungssystem eines elektrischen Kraft fahrzeugsystems verbunden ist, gekennzeichnet durch

   das Schätzen der Energiemenge, die vom durch einen Motor angetriebenen Generator (G) erzeugt werden kann,
   das Erfassen des Ladungszustands einer Batterie (B), die parallel zum Generator (G) geschaltet ist,
   das Vergleichen der geschätzten Energiemenge mit dem durch das Arithmetikmittel (3) berechneten Lastpegel,
   das Bestimmen, ob ein Befehl, der die Steuerung der elektrischen Lastvorrichtungen (1) betrifft, gemäß dem

EP 0 575 622 B1

Vegleichsergebnis und dem erfaßten Ladungszustand der Batterie (B) erzeugt werden sollte oder nicht, und das Steuern der Verringerung des Betriebspegels und des Außerbetriebsetzens der elektrischen Lastvorrichtungen (1) und das Ausgeben eines Alarms in Übereinstimmung mit dem erzeugten Befehl.

**8.** Eine Vorrichtung, die den elektrischen Lastdetektor nach irgendeinem der Ansprüche 1 bis 5 verwendet, der mit einem Multiplex-Übertragungssystem eines elektrischen Kraftfahrzeugsystems verbunden ist, gekennzeichnet durch

ein Entscheidungsmittel, um zu bestimmen, ob ein Befehl (b), der die Drehzahlsteuerung eines Motors betrifft, erzeugt werden sollte oder nicht, und zwar gemäß dem Lastpegel, der auf der Grundlage der Daten (a), die die Steuerung der einzelnen elektrischen Lastvorrichtungen (1) betreffen, und auf der Grundlage der gespeicherten Durchschnittswertdaten durch die Arithmetikschaltung (3) berechnet wird, und durch
ein Änderungsmittel (5) zum Verändern der Leerlaufdrehzahl des Motors in Übereinstimmung mit dem erzeugten Befehl (b).

**9.** Die Vorrichtung nach Anspruch 8, dadurch gekennzeichnet, daß das Änderungsmittel (5) ein Stellglied umfaßt.

**10.** Eine Vorrichtung, die den elektrischen Lastdetektor nach irgendeinem der Ansprüche 1 bis 5 verwendet, der mit einem Multiplex-Übertragungssystem eines elektrischen Kraft fahrzeugsystems verbunden wird, gekennzeichnet durch

ein Schätzungsmittel (32) zum Schätzen der Energiemenge, die von einem durch einen Motor angetriebenen Generator (G) erzeugt werden kann,
ein Komparatormittel (31), um den vom Arithmetikmittel (3) berechneten Lastpegel mit der vom Schätzungsmittel (32) geschätzten Energiemenge zu vergleichen,
ein Erfassungsmittel (34), um in Bezug auf die elektrischen Lastvorrichtungen (1) den Ladungszustand einer parallel mit dem Generator (G) geschalteten Batterie (B) zu erfassen,
ein Entscheidungsmittel, um zu bestimmen, ob ein Befehl, der die Steuerung der Lastvorrichtungen betrifft, gemäß dem Vergleichsergebnis und dem erfaßten Ladungszustand erzeugt werden sollte oder nicht,
ein Steuerungsmittel (36), um die Verringerung des Betriebspegels oder das Außerbetriebsetzen der Lastvorrichtungen (1) in Übereinstimmung mit dem erzeugten Befehl zu steuern, und
ein Alarmmittel (35), um in Übereinstimmung mit dem erzeugten Befehl einen Alarm auszulösen.

**Revendications**

**1.** Détecteur de niveau de charge électrique pour détecter le niveau de charge de dispositifs de charge électrique d'exploitation (1) dans un système de transmission multiplex dans lequel une pluralité de noeuds multiplex (10,20) ayant différents dispositifs de charge électrique (1) sont interconnectés via une ligne de transmission multiplex commune (L) pour transférer mutuellement des données,
caractérisé par des moyens arithmétiques (3) pour calculer le niveau de charge des dispositifs de charge électrique d'exploitation (1) selon des données (a) relatives à la commande des dispositifs de charge individuels (1), reçues à partir des noeuds multiplex (10,20) via la ligne de transmission multiplex (L), et des données de valeurs moyennes mémorisées, associées aux dispositifs de charge individuels (1) reliés aux noeuds multiplex (10,20), lesdites données de valeurs moyennes mémorisées étant mémorisées dans une table de données numériques (2) dudit détecteur de niveau de charge électrique

**2.** Détecteur de niveau de charge électrique selon la revendication 1,
caractérisé en ce que lesdits moyens arithmétiques (3) calculent le niveau de charge électrique des dispositifs de charge électrique d'exploitation (1) selon les données (a) relatives à la commande des dispositifs de charge individuels (1), reçues via la ligne de transmission multiplex (L), et des données de valeurs moyennes mémorisées associées à des dispositifs de charge continue qui fonctionnent de façon continue et/ou des données de valeurs moyennes mémorisées associées à des dispositifs de charge intermittente qui fonctionnent de façon intermittente, parmi les différents dispositifs de charge électrique.

**3.** Détecteur de niveau de charge électrique selon la revendication 1 ou 2,
caractérisé en ce que lesdits moyens arithmétiques (3) réalisent un calcul correcteur de données de valeurs moyennes mémorisées associées à des dispositifs de charge intermittente en service, basé sur des données représentant le temps de pause ou de service des dispositifs de charge intermittente individuels.

4. Détecteur de niveau de charge électrique selon la revendication 1, 2 ou 3,
caractérisé en ce que lesdits moyens arithmétiques (3) corrigent un niveau de charge électrique calculé, basé sur des données de valeurs moyennes mémorisées, associées aux dispositifs de charge (1) en mode standard, selon des données de correction reçues via la ligne de transmission multiplex (L).

5. Détecteur de niveau de charge électrique selon la revendication 4,
caractérisé en ce que les données de correction incluent des données relatives au temps de pause ou de service de charges intermittentes individuelles en service, et lesdits moyens arithmétiques (3) corrigent les données de valeurs moyennes mémorisées, associées aux charges intermittentes selon les données concernant le temps de pause ou de service des charges intermittentes individuelles.

6. Procédé d'utilisation du détecteur du niveau de charge électrique selon l'une quelconque des revendications 1 à 5, relié à un système de transmission multiplex d'un système électrique d'automobile,
caractérisé en ce qu'il consiste à :

- déterminer si un ordre (b) relatif à la commande de vitesse d'un moteur doit être délivré ou non selon le niveau de charge calculé par les moyens arithmétiques (3) basé sur les données (a) relatives à la commande des dispositifs de charge électrique individuels (1) et aux données de valeurs moyennes mémorisées ; et
- changer la vitesse de ralenti du moteur selon l'ordre délivré (b).

7. Procédé d'utilisation du détecteur du niveau de charge électrique selon l'une quelconque des revendications 1 à 5, relié à un système de transmission multiplex d'un système électrique d'automobile, caractérisé en ce qu'il consiste à :

- estimer la quantité de puissance qui peut être engendrée par un générateur (G) entraîné par un moteur ;
- détecter la condition de charge d'une batterie (B) reliée en parallèle au générateur (G) ;
- comparer la quantité de puissance estimée avec le niveau de charge calculé par les moyens arithmétiques (3) ;
- déterminer si un ordre relatif à la commande des dispositifs de charge électrique (1) doit être délivré ou non selon le résultat de la comparaison et la condition de charge détectée de la batterie (B) ; et
- commander la réduction du niveau de service et l'arrêt des dispositifs de charge électrique (1) et délivrer une alarme selon l'ordre délivré.

8. Dispositif qui utilise le détecteur de niveau de charge électrique selon l'une quelconque des revendications 1 à 5, relié à un système de transmission multiplex d'un système électrique d'automobile,
caractérisé par :

- des moyens de décision pour déterminer si un ordre (b) relatif à la commande de vitesse d'un moteur doit être délivré ou non selon le niveau de charge calculé par les moyens arithmétiques (3), basé sur les données (a) relatives à la commande des dispositifs de charge électrique individuels (1), et sur les données de valeurs moyennes mémorisées, et
- par des moyens de changement (5) pour changer la vitesse de ralenti du moteur selon l'ordre délivré (b).

9. Dispositif selon la revendication 8,
caractérisé en ce que lesdits moyens de changement (5) comprennent un actionneur.

10. Dispositif qui utilise le détecteur de niveau de charge électrique selon l'une quelconque des revendications 1 à 5, relié à un système de transmission multiplex d'un système électrique d'automobile,
caractérisé par :

- des moyens d'estimation (32) pour estimer la quantité de puissance qui peut être engendrée par un générateur (G) entraîné par un moteur ;
- des moyens de comparaison (31) pour comparer le niveau de charge calculé par les moyens arithmétiques (3) avec la quantité de puissance estimée à partir desdits moyens d'estimation (32) ;
- des moyens de détection (34) pour détecter, en relation avec les dispositifs de charge électrique (1), la condition de charge d'une batterie (B) reliée en parallèle au générateur (G) ;
- des moyens de décision (33) pour déterminer si un ordre concernant la commande des dispositifs de charge doit être délivré ou non selon le résultat de comparaison et la condition de charge détectée ;

- des moyens de commande (36) pour commander la réduction du niveau de service ou l'arrêt des dispositifs de charge (1) selon l'ordre délivré ; et
- des moyens d'alarme (35) pour délivrer une alarme selon l'ordre délivré.

# FIG. 1

POWER LINE N
MULTIPLEX TRANSMISSION LINE L

B

G

10    MULTI-PLEX NODE    10    MULTI-PLEX NODE    a

2
3
4

20

SW

1  1  SW

ACTUATOR    5

# FIG. 2

POWER LINE N
MULTIPLEX TRANSMISSION LINE L

B

G

MULTI-PLEX NODE    MULTI-PLEX NODE    a    MULTIPLEX NODE

SW1    10    10

IINT

SW2

AVERAGE VALUE TABLE FOR CONTINUOUS LOADS

AVERAGE VALUE TABLE FOR INTERMITTENT LOADS

20    2a    2    2b

3    ARITHMETIC CIRCUIT

5    4

ACTUATOR ←  b    DECISION CIRCUIT

FIG. 3

CURRENT $I_{INT}$ (A)

6A

0

Isec. 5sec.

T

FIG. 4

POWER LINE N

MULTIPLEX TRANSMISSION LINE L

B

G

MULTI-PLEX NODE

MULTI-PLEX NODE

MULTIPLEX NODE

10

SW1

VR

$I_{INT}$

10

SW2

AVERAGE VALUE TABLE FOR CONTINU-OUS LOADS IN STANDARD MODE

AVERAGE VALUE TABLE FOR INTERMIT-TENT LOADS IN STANDARD MODE

20

2a

2

2b

3

ARITHMETIC CIRCUIT

5

4

ACTUATOR

DECISION CIRCUIT

14

# F I G. 5

(a) CURRENT I INT (A)
(EXAMPLE IN
STANDARD MODE)

6 A

1 sec. 5 sec

(b) CURRENT I INT (A)
(EXAMPLE IN
NONSTANDARD MODE)

6 A

1 sec. 2 sec

# F I G. 6

| 30 | 32 | 34 |
|---|---|---|
| ELECTRICAL LOAD DETECTOR | CIRCUIT FOR ESTIMATING THE QUANTITY OF POWER THAT CAN BE GENERATED | BATTERY CHARGE CONDITION DETECTOR CIRCUIT |

COMPARATOR CIRCUIT — 31

DECISION CIRCUIT — 33

CONTROL CIRCUIT

36

• • • •

DIVERSE LOAD DEVICES

35

ALARM DISPLAY UNIT